# EUROPEAN PATENT APPLICATION

(11) **EP 4 782 792 A1**
(43) Date of publication of application: **29.07.2026**
(21) Application number: 26150421.1
(22) Date of filing: 06.01.2026
(51) Int. Cl.: G01D 5/14, G01R 33/09, H01F 7/02

(54) **A MAGNETIC ARRANGEMENT FOR A MAGNETIC SENSING DEVICE**

(30) Priority: 28.01.2025 US 202563750610 P
(71) Applicant: Analog Devices International Unlimited Company, Co. Limerick (IE)
(72) Inventor: Schmitt, Jochen, Co. Limerick (IE)
(74) Representative: Halliwell, Bethan Frances

(57) **Abstract**

The present disclosure provides a magnetic arrangement for use with a magnetic sensing device comprising an angle sensor and multi-turn sensor, the magnetic sensing device being arranged in off-shaft position. Specifically, the present disclosure provides a diametrically magnetized magnet in which the amount of magnetic material in the region of the magnetic poles is reduced relative to the regions between the magnet poles to thereby provide a more homogenous magnetic flux density. In doing so, this enables the magnet and the sensing device to be arranged more compactly. The present disclosure also provides a method of magnetising the magnetic arrangements described herein for improving the accuracy of the angle sensing measurements when the sensing device is placed in an off-shaft position, wherein the magnet is magnetised in a specific direction by applying a current to two sets of electrical conductors positioned on opposite sides of the magnet.

## Description

### Field of Disclosure

The present disclosure relates to a magnetic arrangement for a magnetic sensing device. In particular, the present disclosure relates to a magnetic arrangement for use with a magnetic sensing device comprising an angle sensor and multi-turn sensor, the magnetic sensing device being arranged in an off-shaft position.

### Background

Magnetic single turn sensors and multi-turn sensors are commonly used in applications where there is a need to monitor both the number of times a device has been turned and its precise angular position. An example is a steering wheel in a vehicle. Magnetic multi-turn sensors and single turn sensors typically use magnetoresistive elements that are sensitive to an applied external magnetic field. The resistance of the magnetoresistive elements in multi-turn sensors can be changed by rotating a magnetic field within the vicinity of the sensor. Variations in the resistance of the magnetoresistive elements can be tracked to determine the number of turns in the magnetic field, which can be translated to a number of turns in the device being monitored. Similarly, variations in the resistance of the magnetoresistive elements in single turn sensors can be tracked to determine the magnetic field angle, which can be translated to the angular position of the device being monitored.

### Summary of the Disclosure

The present disclosure provides a magnetic arrangement for use with a magnetic sensing device comprising an angle sensor and multi-turn sensor, the magnetic sensing device being arranged in off-shaft position. Specifically, the present disclosure provides a diametrically magnetized magnet in which the amount of magnetic material in the region of the magnetic poles is reduced relative to the regions between the magnet poles to thereby provide a more homogeneous magnetic flux density. In doing so, this enables the magnet and the sensing device to be arranged more compactly. The present disclosure also provides a method of magnetising the magnetic arrangements described herein for improving the accuracy of the angle sensing measurements when the sensing device is placed in an off-shaft position, wherein the magnet is magnetised in a specific direction by applying a current to two sets of electrical conductors positioned on opposite sides of the magnet.

An aspect of the present disclosure provides a magnetic arrangement for use in a magnetic sensing system. The magnetic sensing system comprises a magnetic sensing device arranged at a position offset from a rotational axis of the magnetic arrangement, wherein the magnetic arrangement comprises: a diametrically magnetized magnet having a substantially cylindrical configuration, the magnet having a first region corresponding to a first magnetic pole and a second region corresponding to a second magnetic pole, the first and second magnetic poles being arranged in diametrically opposite positions; and an aperture extending from a top surface to a bottom surface of the magnet, the aperture being configured to receive a rotatable shaft. The magnet comprises a reduced amount of magnetic material in the first and second regions relative to an amount of magnetic material therebetween.

As such, a magnetic arrangement is provided that enables a magnetic sensing device, in particular, one comprising a magnetic multi-turn sensor and an angle sensor, to be arranged in a position offset from a rotational axis of the magnetic arrangement, thus enabling the space directly under the rotating shaft to be used for other components. For example, other parts of the mechanical system or other electrical components such as encoders, to thereby ensure a compact arrangement. By reducing the amount of magnetic material in the regions of the magnetic poles relative to the rest of the magnet, a more homogeneous magnetic flux density around the circumference of the magnet is generated, such that the magnetic sensing device experiences a uniform magnetic field as the magnet rotates. Consequently, fluctuations in magnetic field strength experienced by the magnetic sensing device are minimised, thus improving the accuracy and reliability of the sensor measurements.

The term 'substantially cylindrical' may be taken to mean a range of shapes with generally circular cross-sections, including but not limited to circles, ellipses and rings.

In some arrangements, the magnet may comprise a varying height profile, the height profile in the first and second regions being relatively lower than the height profile therebetween. That is to say, the thickness and thus volume of magnetic material in the regions of the magnetic field is lower relative to the rest of the magnet. In particular, the maximum of the height profile may be provided in the mid-point between to the magnetic poles, and the minimum of the height profile may be provided in the regions of the magnetic poles.

In some arrangements, the magnet may comprise at least one cut-out to thereby reduce the amount of magnetic material in the first and second regions.

For example, at least one cut-out may be formed in a portion of the top surface of the magnet in the regions of the magnetic poles. By providing at least one cut-out, the amount of magnetic material in the region of the magnetic poles may be reduced compared to the amount of magnetic material in the rest for the magnet, in particular, the regions perpendicular. This reduces the volume of magnetic material in the region where the magnetic field is typically stronger relative to the rest of the magnet, thus providing a more homogeneous magnetic flux density about the circumference of the magnet. In doing so, when arranged in an offset position, the magnetic sensing device will experience a substantially uniform magnetic field as the magnet rotates.

In some arrangements, the at least one cut-out may extend between the first region and the second region.

That is to say, the cut-out may extend through a central portion of the magnet and into the first and second regions such that amount of magnetic material in these areas are reduced, whilst no magnetic material is removed from the outer sides of the magnet to thereby provide a larger amount of magnetic material in the areas between the magnet poles about the circumference of the magnet. It will be appreciated that the at least one cut-out may extend partially into or all the way through the first and the second regions.

In some arrangements, the at least one cut-out may have a substantially rectangular profile. Such an arrangement provides a magnetic arrangement that is easy to manufacture whilst still providing a more homogeneous magnetic flux density around the circumference of the magnet.

In some arrangements, the at least one cut-out may comprise a sloped surface. By providing the cut-out with a sloped profile, the amount of magnetic material may be gradually varied around the circumference of the magnet, and in doing so, reduce fluctuations in the magnetic flux density that may be caused by a sharp change in volume.

In some arrangements, the magnet may comprise a plurality of cut-outs to thereby provide the reduced amount of magnetic material in the first and second regions relative to the amount of magnetic material therebetween.

In this respect, the plurality of cut-outs may be arranged around the circumference of the magnet so that the height profile and thus amount of magnetic material is gradually reduced towards the regions of the magnetic poles, thus helping to prevent sudden changes in field strength as the amount of magnetic material is varied.

In some arrangements, the magnet may comprise at least one cut-out in the first and second regions, and a plurality of further cut-outs extending around at least a portion of a circumference of the magnet. In this respect, it will be appreciated that any suitable number of further cut-outs may be provided. For example, one further cut-out may be provided either side of the first and second regions. As another example, two or more further cut-outs may be provided either side of the first and second regions in order to provide a more gradual change in the amount of magnetic material around the circumference of the magnet.

The depth of the at least one cut-out in the first and second regions may be greater than the depths of the plurality of further cut-outs. In cases where there are two or more further cut-outs provided either side of the first and second regions, the depth of each cut-out may be made progressively deeper towards the first and second regions, thus providing a gradual reduction in the amount of magnetic material the closer it gets to the magnetic poles.

In some arrangements, the top surface of the magnet may comprise a sinusoidal configuration to thereby provide the varying height profile. That is to that, the top surface may have an undulating profile, similar to that of a sinusoidal wave, wherein the top surface varies such that the height of the magnet is lowest in the regions of the magnetic poles (i.e., equivalent to the trough of a sinusoidal wave) and highest in the regions perpendicular thereto (i.e., equivalent to the peak of a sinusoidal wave), with a gradual incline between these regions. The smooth, sinusoidal profile of the magnet thus provides a more gradual change in the amount of magnetic material, to thereby prevent sudden changes in field strength as the volume of magnetic material changes, thus providing a more equalised and homogeneous magnetic field experienced by a sensing device located in an offset position

In some arrangements, the magnet may have one of an elliptical configuration. Similarly, the aperture may have an elliptical configuration.

That is to say, diameter of the magnet may be larger in one direction (e.g., the semi-major axis) compared to the diameter in the perpendicular direction (e.g., the semi-minor axis). In such cases, the magnetic poles may be arranged along the semi-major axis, such that the amount of magnetic material in these regions is reduced relative to the parts of the magnet arranged along the semi-minor axis.

In other arrangements, the magnet and/or aperture may have a circular configuration.

A further aspect of the disclosure provides a magnetic arrangement for use in a magnetic sensing system, the magnetic sensing system comprising a magnetic sensing device arranged at a position offset from a rotational axis of the magnetic arrangement, wherein the magnetic arrangement comprises: a diametrically magnetized magnet having a substantially cylindrical configuration, the magnet having a first region corresponding to a first magnetic pole and a second region corresponding to a second magnetic pole, the first and second magnetic poles being arranged in diametrically opposite positions; and an aperture extending from a top surface to a bottom surface of the magnet, the aperture being configured to receive a rotatable shaft; wherein the magnet is configured such that the first and second regions are formed in a first plane perpendicular to the rotational axis of the magnetic arrangement, and the aperture is formed in a second plane perpendicular to the rotational axis of the magnetic arrangement, the first plane being different from the second plane.

By providing the regions of the magnet poles in a first plane and the aperture and the regions between the magnetic poles lie in a second plane different to that of the first, the magnetic sensing device may positioned such that it sits closer to the parts of the magnet where the magnetic flux density is weaker and further from the parts of the magnet where the magnetic flux density is stronger. Consequently, the magnetic sensing device will experience an overall homogeneous magnetic field as the magnet rotates.

In some arrangements, the magnetic sensing device may be arranged proximal to the second plane. In this respect, it will be appreciated that the magnetic sensing device may be arranged substantially in line with the second plane, or at least closer in distance to the second plane than the first plane.

Another aspect of the disclosure provides a magnetic sensing system, comprising: a magnetic arrangement according to the aspects described above; and a magnetic sensing device, the magnetic sensing device at least comprising an angle sensor configured to detect an angular rotation of the magnetic field generated by the magnetic arrangement, and a multi-turn sensor configured to detect a number of turns of the magnetic field generated by the magnetic arrangement; wherein the magnetic sensing device is arranged at a position offset from a rotational axis of the magnetic arrangement.

The magnetic sensing device may be at a first position within a plane perpendicular to the rotational axis of the magnet.

In some arrangements, the multi-turn sensor may be a giant magnetoresistive (GMR) or tunnel magnetoresistive (TMR) based multi-turn sensor.

In some arrangements, the angle sensor may be an anisotropic magnetoresistive (AMR) based angle sensor.

It will be appreciated that the multi-turn and/or angle sensor may also be any other suitable sensor, such as a Hall sensor.

Yet another aspect of the disclosure provides a method for magnetising a magnetic arrangement for use in a magnetic sensing system, the magnetic sensing system comprising a magnetic sensing device arranged at a position offset from a rotational axis of the magnetic arrangement, wherein the method comprises: providing a magnetic arrangement according to the aspects described above; placing the magnetic arrangement in proximity to at least one set of electrical conductors; applying a current pulse to the at least one set of conductors, such that a magnetic field is generated to thereby magnetize the magnet in a predetermined direction.

Accordingly, the magnet may be magnetised in a specific direction by applying a current to electrical conductors positioned near to the magnet. This ensures that the magnetic field experienced by a magnetic sensing device, in particular, an angle sensor, at each angular position around the circumference of the magnet will result in a corresponding change in magnetisation direction within the sensing material of the sensor, to thereby enable accurate measurements of the rotation angle to be made.

The at least one set of conductors may comprise a first set of conductors and a second set of conductors, wherein the magnetic arrangement is placed between the first and second set of conductors.

In some arrangements, the first set of conductors may comprise a first coil, and the second set of conductors may comprise a second coil.

The first and second set of conductors may be arranged on opposing sides of the magnetic arrangement.

The first and second set of conductors may be arranged along an axis corresponding to the predetermined direction.

A yet further aspect of the disclosure provides a method for magnetising a magnetic arrangement for use in a magnetic sensing system, the magnetic sensing system comprising a magnetic sensing device arranged at a position offset from a rotational axis of the magnetic arrangement, wherein the method comprises: providing an anisotropic magnetic material in a liquid or powder form into a mold of required shape; placing the anisotropic magnetic material in proximity to at least one set of electrical conductors and applying a current to the at least one set of electrical conductors to generate a magnetic field (e.g., the current may be configured to generate a constant magnetic field) in a predetermined direction to thereby align the magnetic particles of the anisotropic magnetic material in the predetermined direction; solidifying the anisotropic magnetic material to form a magnetic arrangement according to the aspects described above; and applying a further magnetic field to thereby magnetize the magnetic arrangement.

The at least one set of conductors may comprise a first set of conductors and a second set of conductors, wherein the anisotropic magnetic material is placed between the first and second set of conductors.

The first set of conductors may comprise a first coil, and the second set of conductors may comprise a second coil.

The first and second set of conductors may be arranged on opposing sides of the anisotropic magnetic material.

The first and second set of conductors may be arranged along an axis corresponding to the predetermined direction.

### Brief Description of the Drawings

The present disclosure will now be described by way of example only with reference to the accompanying drawings in which:
Figure 1 is a perspective view of a magnetic sensing device in accordance with an embodiment of the disclosure;
Figure 2A illustrates an example of the magnetic sensing device of Figure 1 arranged in an off-shaft position;
Figure 2B further illustrates the arrangement shown in Figure 2A;
Figures 3A-B illustrate an example of a magnetic arrangement in accordance with an embodiment of the disclosure, with the magnetic sensing device of Figure 1 arranged in an off-shaft position;
Figure 4A illustrates the magnetic flux density of the arrangement shown in Figure 2A;
Figure 4B illustrates the magnetic flux density of the arrangement shown in Figures 3A-B;
Figure 5 an example of a magnetic arrangement in accordance with an embodiment of the disclosure, with the magnetic sensing device of Figure 1 arranged in an off-shaft position;
Figure 6 illustrates a further example of a magnetic arrangement in accordance with an embodiment of the disclosure, with the magnetic sensing device of Figure 1 arranged in an off-shaft position;
Figure 7 illustrates the magnetic flux density of the arrangement shown in Figure 5;
Figure 8 is another example of a magnetic arrangement in accordance with the present disclosure, which may be used with a sensing device such as that shown in Figure 1;
Figures 9A-C illustrate an example of the arrangement shown in Figure 3A in use;
Figure 10 illustrates an example of an arrangement for magnetising the magnet shown in Figure 3A;
Figures 11A-C illustrate a further example of the arrangement shown in Figure 3A in use;
Figure 12 is a flow diagram illustrating an example method of manufacturing a magnetic arrangement according to the present disclosure;
Figure 13 is a flow diagram illustrating an example method of manufacturing a magnetic arrangement according to the present disclosure;
Figure 14 illustrates a further example of a magnetic arrangement in accordance with an embodiment of the disclosure with the magnetic sensing device of Figure 1 arranged in an off-shaft position;
Figure 15 illustrates a further example of a magnetic arrangement in accordance with an embodiment of the disclosure;
Figure 16 illustrates yet a further example of a magnetic arrangement in accordance with an embodiment of the disclosure;
Figure 17 illustrates another example of a magnetic arrangement in accordance with an embodiment of the disclosure.

### Detailed Description

Magnetic multi-turn and single turn sensors can be used to monitor the turn count and angular position of a rotating shaft. Such magnetic sensing can be applied to a variety of different applications, such as automotive applications, medical applications, industrial control applications, consumer applications, and a host of other applications which require information regarding a position of a rotating component.

The present disclosure provides a magnetic arrangement for use with a magnetic sensing device comprising an angle sensor and multi-turn sensor, the magnetic sensing device being arranged in off-shaft position. That is to say, the sensing device is not arranged directly in line with the longitudinal axis of the rotating shaft on which the magnet is located, and is instead offset from the rotational axis of the magnet. In doing so, the space directly under the rotating shaft can be used for other components, for example, other parts of the mechanical system or other electrical components such as encoders, to thereby ensure a compact arrangement. However, when a magnetic sensing device is arranged in an off-shaft position, it is important that the magnetic sensing device experiences a uniform magnetic flux density as the magnet rotates in order to provide accurate and reliable measurements. The present disclosure thus provides a magnetic arrangement that enables the magnetic sensing device to be arranged in the off-shaft position, whilst still providing accurate and reliable measurements of the shaft rotation.

In the present disclosure, the magnetic sensing device comprises a magnetic angle sensor and a magnetic multi-turn (MT) sensor, which may be packaged together on a single lead frame. The angle sensor described herein may be an anisotropic magnetoresistance (AMR), tunnel magnetoresistance (TMR), giant magnetoresistance (GMR), Hall or other magnetic based angle sensor. Similarly, the MT sensor described herein may be a tunnel magnetoresistance (TMR) or giant magnetoresistance (GMR) based multi-turn sensor.

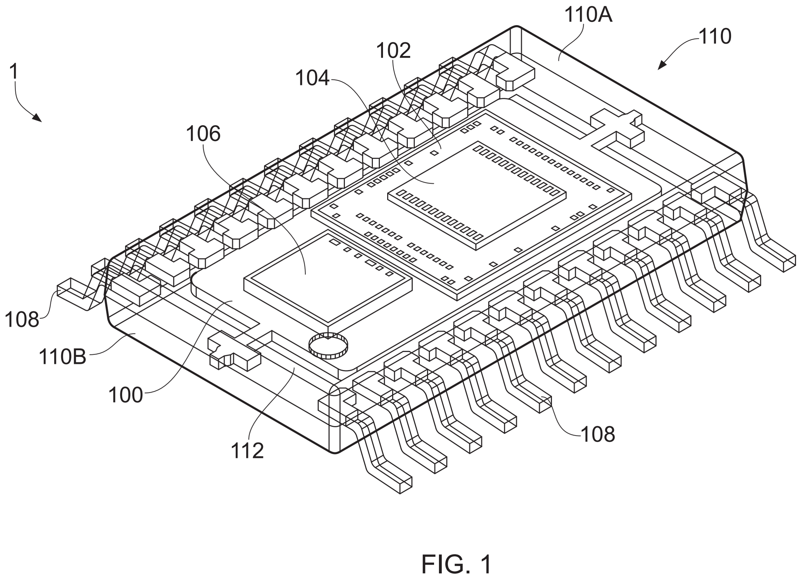

Figure 1 illustrates a magnetic sensing device 1 in accordance with an embodiment of the present disclosure. The magnetic sensing device 1 comprises a package substrate 100, also referred to as the lead frame paddle, which may comprise a laminate substrate such as a printed circuit board (PCB) substrate, ceramic substrate, or any suitable type of substrate. An application specific integrated circuit (ASIC) die 102 is formed onto the package substrate 100, upon which a first integrated device 104 is stacked, the first integrated device 104 in this case comprising a magnetic multi-turn (MT) sensing element configured to count the number of turns in a rotating magnetic field. Adjacent to the ASIC die 102 and MT sensor 104 stack, a second integrated device 106 is provided on the substrate 100, the second integrated device 106 comprising a magnetic angle sensing element configured to measure the angular position of a rotating magnetic field.

It will of course be appreciated that the MT sensor 104 and the angle sensor 106 may be arranged in any suitable configuration within the sensing device 1, for example, the angle sensor 106 may be stacked on top of the MT sensor 104. Similarly, the MT sensor 104 and angle sensor 106 may also be monolithically integrated into the ASIC die 102.

The ASIC die 102, MT sensor 104 and angle sensor 106 can be assembled and fixed to the substrate 100 in any suitable way, for example, using an epoxy die attach or a die attach film (DAF). As a result, the ASIC die 102 and MT sensor 104 stack, as well as the angle sensor 106, can be located close to the edge of the substrate 100, which may be preferable in applications where the sensing device 1 is positioned away from the rotational axis of the magnet.

The package substrate 100 includes leads 108 on the lower surface thereof to facilitate electrical connection to other electronic systems, for example, by way of another board, such as a printed circuit board. The package substrate 100 and leads 108 together can be considered the lead frame of the magnetic sensor package 1. The package substrate 100, ASIC die 102, MT sensor 104 and angle sensor 106 are all housed within a molded package body 110. For example, the package body 110 may comprise a non-conductive molding comprising a dual sided construction. As such, the molded package body 110 may comprise two hollow components 110A, 110B that are attached around the edges, for example, by way of thermal plastic welding or joining techniques such as thermal compression bonding, to form a housing. Electrical connections 112 between the ASIC die 102, MT sensor 104 and angle sensor 106 and the leads 108 may also be housed within the molded package body 110.

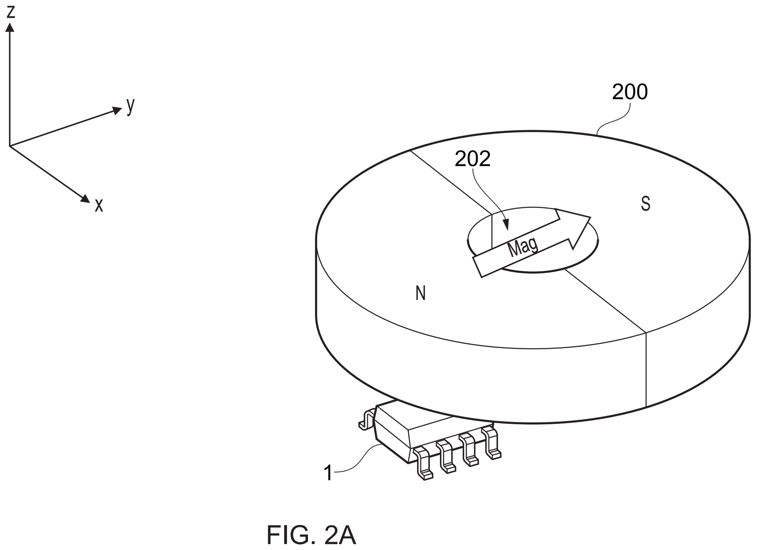

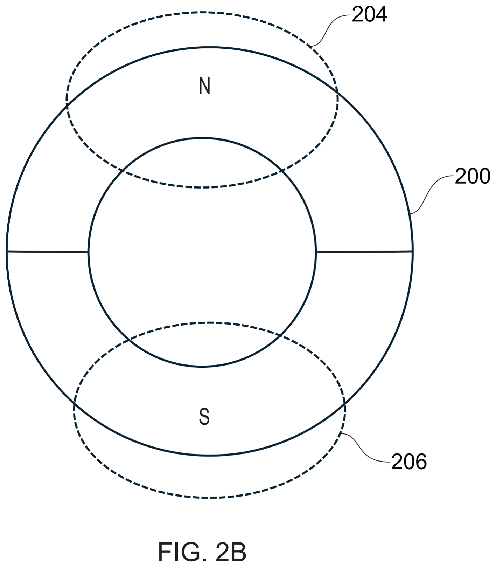

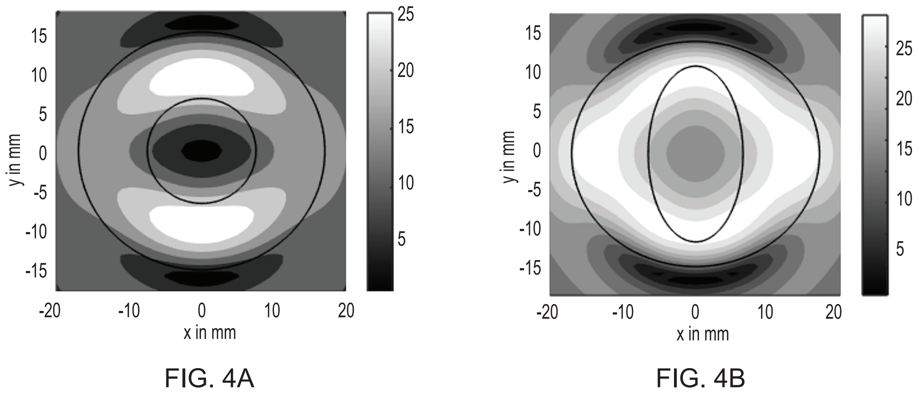

Figure 2A illustrates a first example of how a sensing device 1, such as that shown in Figure 1, may be arranged in an off-shaft position in the case where a diametrically magnetized ring magnet 200 is used. That is to say, the sensing device 1 is arranged at a fixed position within a plane perpendicular to the rotational axis of the magnet 200. The magnet 200 comprises an internal aperture 202 that extends between an upper and lower surface (e.g., in the z-direction) of the magnet 200, both the magnet 200 and the aperture 202 having a substantially circular configuration. However, such an arrangement can result in unreliable sensor measurements, that are susceptible to faults. Figure 4A illustrates the magnetic flux density of a ring magnet 200 (magnetized in the y-direction), such as that shown in Figure 2, at a distance of approximately 5mm above the magnet 200. As can be seen, the magnetic flux density is stronger in the region of the magnetic poles (i.e., in the y-direction). That is to say, with reference to Figure 2B, there will be a larger magnetic flux density in the regions shown generally at 204 and 206. In the remaining regions of the magnet (e.g., where the two halves of the magnet 200 meet) and in the region of the inner hole, a significantly lower magnetic flux density is provided.

Consequently, as the magnet 200 rotates, the magnetic sensing device 1 in the off-shaft position will experience a varying magnetic flux density, which can result in errors in the sensor readings, in particular, the measurements by the angle sensor 106. For example, in the case of magnetoresistive based angle sensors, the magnetoresistive sensing elements (which are typically elongated strips of magnetoresistive film) used therein will have a high shape anisotropy at lower magnet fields. Therefore, in the regions with lower magnetic flux density, the magnetization of the magnetoresistive sensing elements does not solely follow the external rotating magnetic field, but also experiences an additional magnetic force generated by the shape anisotropy as it tries to align the magnetization with the longitudinal axis of the sensing elements, which can lead to a higher level of error at the lower fields. Additionally, in the regions with lower magnetic flux density, stray magnetic fields will have a larger impact, again leading to errors in the sensor outputs of the magnetic sensing device 1.

To address this, the inner diameter of the ring magnet 200 needs to be relatively small to increase the magnetic flux density in the regions outside of the magnet poles, to thereby achieve a good angular error performance in the angle sensor 106. However, this limits the diameter of the rotating shaft on to which the magnet can be installed, thus limiting the number of mechanical systems and applications with which such an arrangement can be used, and thus increasing the size and cost of the magnet required. Additionally, the distance between the magnet 200 and the sensing device 1 (in the z-direction) needs to be relatively large (~20mm) in order to provide good angular error performance, for example, the air gap may need to be approximately 1/3 of the magnet diameter. In this respect, when the sensing device 1 is placed further away from the magnet 200, the magnetic field experienced by the sensing device 1 will be more similar to a magnetic dipole, i.e., more homogenized field strength, thus leading to more reliable sensor measurements, particularly for the angle sensor 106. However, placing the sensing device 1 further away results in a large arrangement in the axial direction, which can be a problem for systems where space is limited and a compact arrangement is needed.

For the MT sensor 104, whilst the angular accuracy can be lower since it only needs to detect every 90° turn, the magnetic flux density still needs to be within the operating window of the MT sensor 104, which defines the lower and upper limits of magnetic field strength in which the MT sensor 104 can reliably operate. As the magnetic flux density experienced by the sensing device 1 in the off-shaft position varies from low to high, this can result in the magnetic field strength experienced by the MT sensor 104 periodically going outside the limits of the operating window, which can result in an incorrect turn count by the MT sensor 104. As such, to address this, a larger air gap between the magnet 200 and the sensing device 1 is again needed.

A larger air gap also requires a magnet to have a stronger magnetization so that the field strength is still detectable by the sensing device 1 (i.e., it is still within the operating window), which requires the magnet to be larger in the axial direction (i.e., thicker) or made from more expensive rare earth materials.

The present disclosure therefore provides an improved magnetic arrangement that provides a more homogeneous magnetic flux density, and enables the magnet and the off-shaft sensing device to be arranged more compactly. Specifically, the present disclosure provides a diametrically magnetized magnet in which the amount of magnetic material in the region of the magnetic poles is reduced relative to the regions between the magnet poles to thereby provide a more homogeneous magnetic flux density.

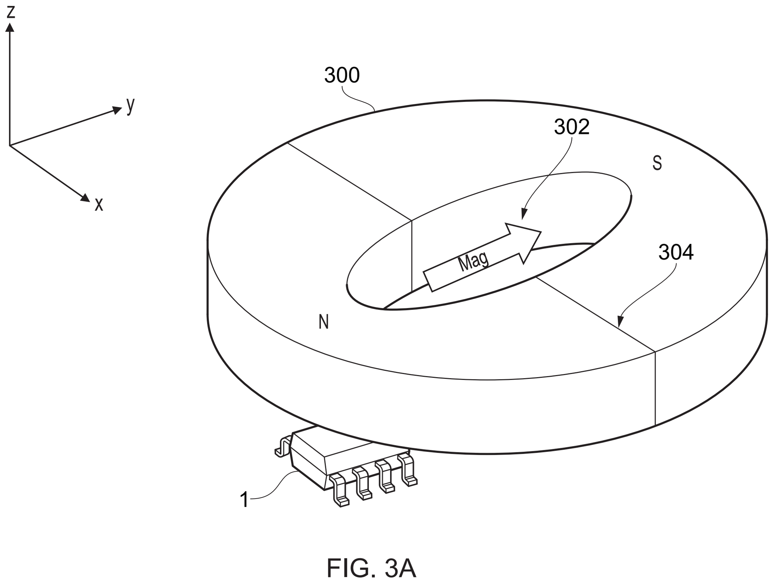

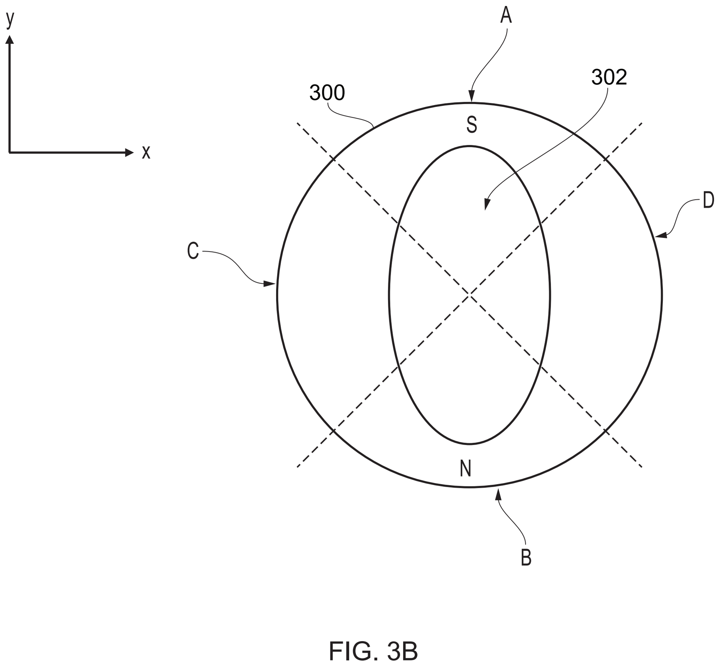

Figure 3A is an example of a magnet 300 in accordance with the present disclosure, which may be used with a sensing device 1 such as that shown in Figure 1. In this example, the magnet 300 is a diametrically magnetized magnet that has a substantially cylindrical configuration, however, the inner and outer edges of the magnet 300 have an elliptical or oval configuration, such that the diameter in one direction (also referred to as the semi-major axis) is larger than the diameter in the perpendicular direction (also referred to as the semi-minor axis), with the internal aperture 302 also having an elliptical configuration. In this example, the semi-major axis is in the y-direction and the semi-minor axis is in the x-direction. The magnet 300 is arranged so that the semi-major axis extends in the direction of the magnet poles (denoted N and S), such that the amount of magnetic material in the region of the magnet poles is reduced, whereas the semi-minor axis extends in the direction perpendicular to the magnetic poles, such that the amount of magnetic material in the regions where the two halves of the magnet meet (i.e., in the region of the line denoted 304) is greater than that in the region of the magnet poles. That is to say, there is a lower volume of magnetic material in the region of the magnetic poles relative to the rest of the magnet 300 (e.g., compared to the regions perpendicular to the magnetic poles). This is further illustrated in Figure 3B, which shows a top view of the magnet 300 shown in Figure 3A, the magnet 300 and the internal aperture 302 again having an elliptical or oval configuration. In this example, the magnet 300 is virtually divided into four regions A-D; the first and second regions A-B defining the regions of the magnetic poles (N, S), and the third and fourth regions C-D defining the regions therebetween. Assuming a constant thickness (i.e., in the z-direction), the elliptical configuration of the magnet 300 means that the magnet 300 comprises less magnetic material in the first and second regions A-B relative to the amount of magnetic material in the third and fourth regions C-D. For example, the volume of magnetic material in the first and second regions A-B may be 30-60% lower than the volume of magnetic material in the third and fourth regions C-D. However, it will be appreciated that any suitable reduction in the amount of magnetic material may be provided to thereby achieve a homogeneous magnetic field around the circumference of the magnet 300.

Figure 4B illustrates the magnetic flux density of an elliptical magnet 300 (magnetized in the y-direction), from which it can be seen that the magnetic flux density in x-y plane around the circumference of the magnet 300 (i.e., perpendicular to the rotating axis z) is substantially the same. That is to say, by reducing the amount of magnetic material in the region where the magnetic field is stronger (i.e., at the magnetic poles) relative to the amount of magnetic material in rest of the magnet 300, a more equalised magnetic flux density can be obtained. That is to say, the field strength in the region of the magnetic poles is effectively reduced to a level that is substantially the same as that of the other regions of the magnet 300. In doing so, the sensing device 1 will experience substantially the same magnetic field strength at all angles as the magnet 300 rotates, even with a small air gap between the sensing device 1 and the magnet 300. By providing a magnet 300 with a more homogeneous magnetic flux density, this improves the error performance of the angle sensor 106 and helps to ensure magnetic field strength stays within the operating window of the MT sensor 104. As the sensing device 1 can be placed closer to the magnet 300 without compromising performance, this helps to provide a more compact arrangement in use. In use, the inner aperture 302 of the magnet 300 will be configured so that the width of the aperture 302 in the direction of semi-minor axis corresponds to the diameter of the rotating shaft on which it is to be installed, to ensure it is robustly coupled to the shaft and thus rotates with the shaft.

Although the example of Figure 3A shows an elliptical ring, it will be appreciated that other shapes providing a similar effect on the magnetic flux density may also be used, such as an oblong toroid. Similarly, a magnet having a substantially hexagonal, octagonal or any other polygonal shape may also be used, provided the shape is configured such that there is a lower volume of magnetic material in the regions of the magnetic poles to thereby provide a more homogeneous magnetic flux density in the x-y plane.

In the example of Figure 3A, the magnet 300 is described as having a region of the magnet poles and regions where the two halves of the magnet 300 meet (i.e., the line denoted 304). It will of course be appreciated that the magnet 300 may be formed of two separate pieces of magnetic material joined together or a single piece of magnetic material. As such, the line 304 may denote the physical boundary between two constituent parts of the magnet 304, or a virtual halfway point between the north and south poles. As such, the magnet 300 may also be considered to comprise a first region corresponding to a first magnetic pole, a second region corresponding to a second magnetic pole as and a connecting region disposed between the first and the second regions.

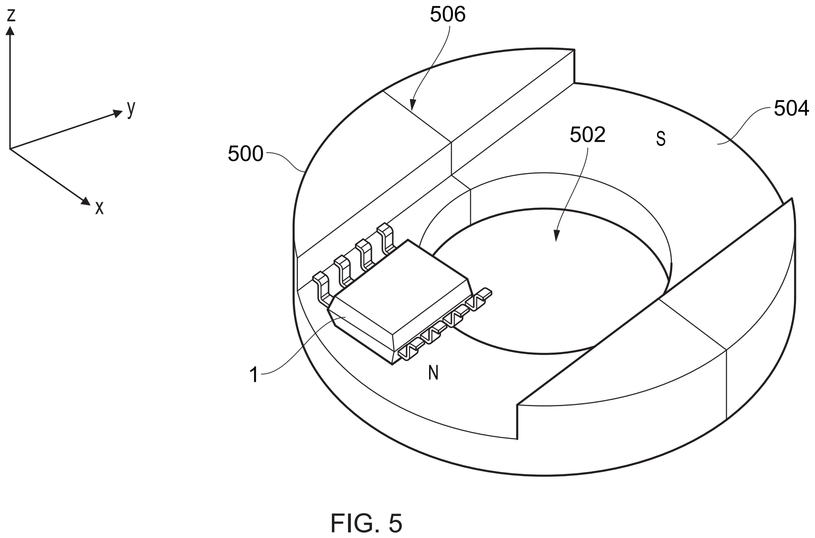

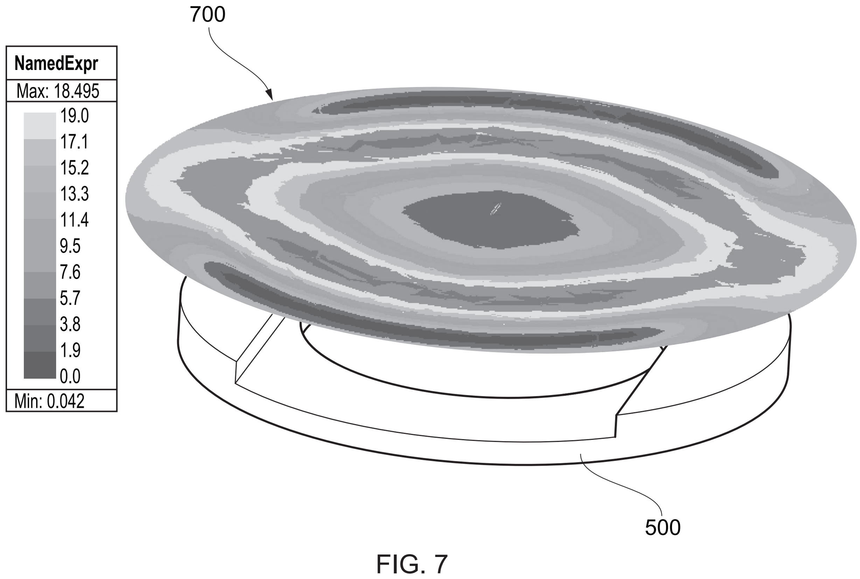

Figure 5 is a further example of a magnet 500 in accordance with the present disclosure, which may again be used with a sensing device 1 such as that shown in Figure 1. In this example, the magnet 500 is a diametrically magnetized ring magnet comprising an aperture 502 and a central cut-out 504 in the region of the magnetic poles (denoted N and S). In this respect, the cut-out 504 is provided such that a region of the upper surface of the magnet (i.e., in the z-direction) is removed, although it will be appreciated that the cut-out may also be provided on the lower surface. As such, the amount of magnetic material in the region of the magnetic poles is reduced compared to the amount of magnetic material in the region where the two halves of the magnet 500 meet (shown generally as 506), again resulting in a more homogeneous magnetic flux density about the circumference of the magnet 500, as illustrated by the flux density map 700 shown in Figure 7. Similarly to the example shown in Figure 3A, the volume of magnetic material in the regions of the magnetic poles (i.e., the region of the cut-out 504) may be 30-60% lower than the volume of magnetic material in the regions therebetween (i.e., where there is no cut-out). As with the example shown in Figure 3A, the sensing device 1 can thus be arranged closer to the magnet 500, to thereby provide a more compact arrangement. Moreover, by configuring the magnet 500 in this way, the inner aperture 502 can be made larger without compromising performance, thus enabling it to be used in systems with larger rotating shafts.

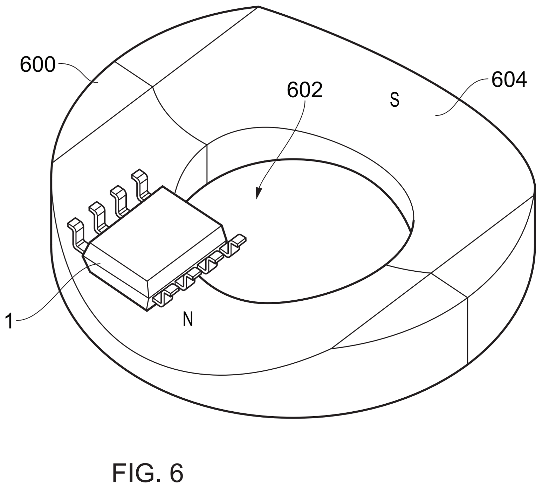

Figure 6 is yet a further example of a magnet 600 in accordance with the present disclosure, which may again be used with a sensing device 1 such as that shown in Figure 1. The magnet 600 is similar to that shown in Figure 5 in that it is a diametrically magnetised ring magnet 600 with a circular inner aperture 602 and a central cut-out 604 in the region of the magnetic poles, however, in this example, the central cut-out 604 has a smooth inclined profile, such that the cut-out 604 is more rounded, rather than the rectangular shaped cut-out shown in Figure 5. In this case, 'profile' is intended refer to height profile, for example in the Z-direction.

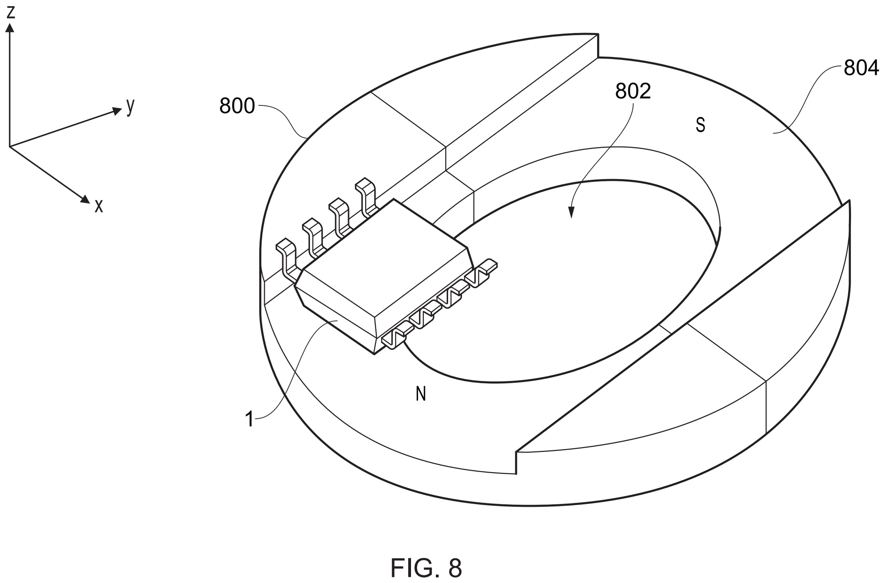

Figure 8 is another example of a magnet 800 in accordance with the present disclosure, which may again be used with a sensing device 1 such as that shown in Figure 1. The magnet 800 is a diametrically magnetized magnet wherein the magnet 800 and inner aperture 802 have an elliptical configuration, similar to that of Figure 3A, however, in this example, the magnet 800 also comprises a central cut-out 804 in the region of the magnetic poles, similar to that shown in Figure 5. It will of course be appreciated that the cut-out 804 may also have a smooth inclined profile such as that shown in Figure 6. By combining the two techniques, the magnet 800 can be easily adjusted to the desired field strength and magnet size, which may depend on the intended use of the sensing system. For example, by also having a cut-out 804, the extent of the elliptical shape can be adjusted to the size of the rotating shaft. That is to say, the diameter of inner and outer edges of the magnet 800 in the direction of the semi-major axis (i.e., the y-direction in Figure 8) can be made smaller, and the diameter of inner and outer edges of the magnet 800 in the direction of the semi-minor axis (i.e., the x-direction in Figure 8) can be made larger, such that the width of the aperture 802 in the direction of semi-minor axis is increased to accommodate a larger shaft diameter.

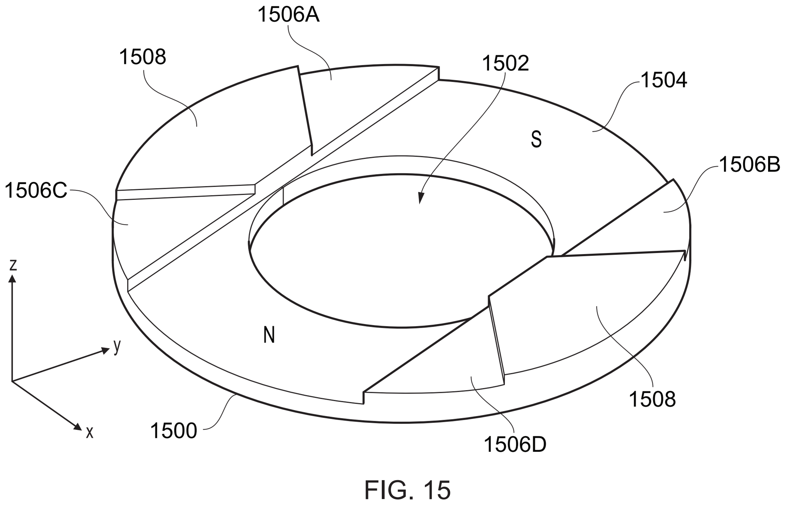

Figure 15 is another example of a magnet 1500 in accordance with the present disclosure, which may again be used with a sensing device 1 such as that shown in Figure 1 in an "off-shaft" position. The magnet 1500 is a diametrically magnetized magnet, wherein the magnet 1500 and inner aperture 1502 have a circular configuration. In the example of Figure 15, the magnet 1500 is provided with a plurality of cut-outs, including a first cut-out 1504 similar to that shown in Figure 5, and a plurality of further cut-outs 1506A-D proximal to the first cut-out 1504, such that each magnetic pole (N, S) sits between two of the further cut-outs 1506A-D, thus providing the magnet 1500 with a varying height profile (i.e., in the z-direction). That is to say, the plurality of further cut-outs 1506A-B comprises a first pair of further cut-outs 1506A-B positioned either side of a first region corresponding to a first magnetic pole (S) and a second pair of further cut-outs 1506C-D positioned either side of a second region corresponding to a second magnetic pole (N). The depth of the first cut-out 1504 is greater than the depth of the further cut-outs 1506A-D, to thereby provide a varying height profile (i.e., thickness in the z-direction) between the regions of the magnetic poles (N, S) and the regions perpendicular to the magnetic poles (shown generally as 1508). In doing so, the volume of magnetic material is reduced in the regions of the further cut-outs 1506A-D (relative to the regions 1508), and then further reduced in the region of the first cut-out 1504 (i.e., the magnetic poles). By having a more gradual transition between changes in the height profile, this helps to prevent sudden fluctuations in the magnetic field strength as the volume of magnetic material changes, thus providing a more equalised and homogeneous magnetic field experienced by a sensing device 1 located in an off-shaft position. As such, by having more cut-outs and a more gradual change in the volume of magnetic material, the change in magnetic field is less acute at the edges of each cut-out, which means that the magnetic sensing device 1 can be placed very close to the magnet 300 (i.e., in the z-direction) without affecting the sensor readings, thus providing an overall more compact arrangement. Whilst the magnet 1500 in Figure 15 is shown as having a circular configuration, it will of course be appreciated that the magnet 1500 and inner aperture 1502 may also have any suitable configuration, such as an elliptical configuration.

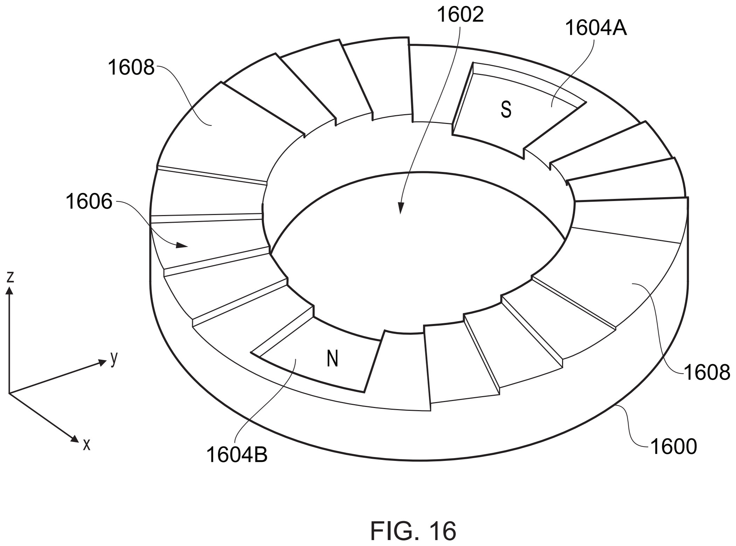

Figure 16 is another example of a magnet 1600 in accordance with the present disclosure, which may again be used with a sensing device 1 such as that shown in Figure 1 in an "off-shaft" position. As with previous examples, the magnet 1600 is a diametrically magnetized magnet, wherein the magnet 1600 and inner aperture 1602 have a circular configuration. In the example of Figure 16, the magnet 1600 is again provided with a varying height profile that gradually increases from the regions of the magnetic poles (N, S) towards the regions perpendicular thereto (shown generally at 1608), to thereby provide a magnetic arrangement where the amount of magnetic material in the regions of the magnetic poles is reduced relative to the rest of the magnet 1600. The varying height profile is provided by a first set of cut-outs 1604A-B in the regions of the magnetic poles, and a plurality of further cut-outs (shown generally as 1606) of varying depths that extend around at least a portion of the circumference of the magnet 1700. That is to say, starting from the first set of cut-outs 1604A-B in the region of the magnetic poles (N, S), the depth of each adjacent cut-out 1606 gradually decreases to thereby provide a gradual increase in height profile and the volume of magnet material. In this respect, the volume of magnetic material in the region of the magnetic poles (i.e., corresponding to the first set of cut-outs 1604A-B) is relatively lower than the other regions of the magnet 1600 (i.e., corresponding to the plurality of further cut-outs 1606 and the regions 1608 perpendicular to the magnetic poles). As such, the magnet 1600 is similar to that of Figure 15, but with a higher number of further cut-outs 1606 between the magnetic poles (N, S) and the regions 1608 perpendicular thereto, thus providing an even more gradual change in the amount of magnetic material. By having more gradual transitions as the height profile changes, this reduces the amount of fluctuation in the magnetic flux density about the circumference of the magnet 1600 that can occur as the volume of magnetic material changes, thus providing a more equalised and homogeneous magnetic field experienced by a sensing device 1 located in an off-shaft position. Whilst the magnet 1600 in Figure 16 is shown as having a circular configuration, it will of course be appreciated that the magnet 1600 and inner aperture 1602 may also have any suitable configuration, such as an elliptical configuration.

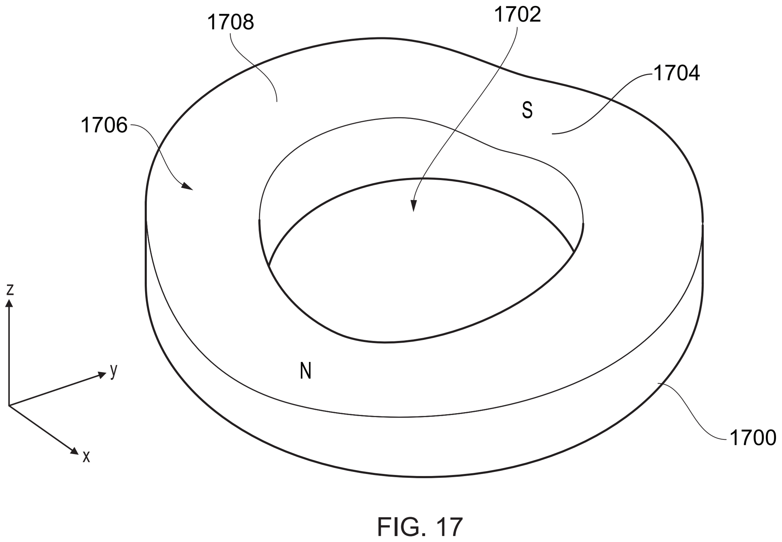

Figure 17 is further example of a magnet 1700 in accordance with the present disclosure, which may again be used with a sensing device 1 such as that shown in Figure 1 in an "off-shaft" position. As with previous examples, the magnet 1700 is a diametrically magnetized magnet, wherein the magnet 1700 and inner aperture 1702 have a circular configuration. In the example of Figure 17, the magnet 1700 is again provided with a varying height profile that gradually increases from the regions of the magnetic poles (shown generally at 1704) towards the regions perpendicular thereto (shown generally at 1708). In this example, a portion of the magnet 1700 is cut-out so as to provide an outer surface 1706 of the magnet 1700 has an undulating profile, similar to that of a sinusoidal wave with a period of 180°. In this respect, the outer surface 1706 varies such that the height of the magnet 1700 is lowest in the regions 1704 of the magnetic poles (i.e., equivalent to the trough of the sinusoidal wave) and highest in the regions 1708 perpendicular thereto (i.e., equivalent to the peak of the sinusoidal wave), with a gradual incline between these regions. This again provides a magnetic arrangement where the amount of magnetic material in the regions 1704 of the magnetic poles is reduced relative to the rest of the magnet 1700, to thereby provide a more homogeneous magnetic flux density about the circumference of the magnet 1700. The smooth, sinusoidal profile of the magnet 1700 provides a more gradual change in the amount of magnetic material, which again helps to reduce the amount of fluctuation in the magnetic flux density that might occur as the volume of magnetic material changes, thus providing a more equalised and homogeneous magnetic field experienced by a sensing device 1 located in an off-shaft position. Whilst the magnet 1700 in Figure 17 is shown as having a circular configuration, it will of course be appreciated that the magnet 1700 and inner aperture 1702 may also have any suitable configuration, such as an elliptical configuration.

It will of course be understood that the variation in height profile of the magnets 500, 600, 800, 1500, 1600, 1700 shown in Figures 5, 6, 8, 15, 16 and 17 may be configured in any suitable way, depending on various factors such as the magnetic material used, whether the magnet is isotropic or anisotropic, and how the magnet if made (e.g., bonded or sintered). For example, if the magnet 1500 shown in Figure 15 is formed as an anisotropic magnet, the thickness of the magnet 1500 (i.e., in the z-direction) in the region of the magnetic poles (i.e., at the cut-out 1504) may be approximately 1.3mm and the thickness of the magnetic 1500 in the regions 1508 may be approximately 3mm. As another example, if the magnet 1600 shown in Figure 16 is formed as an isotropic magnet, the thickness of the magnet 1600 in the region of the magnetic poles (i.e., at cut-outs 1604A-B) may be approximately 3.9mm and the thickness of the magnet 1600 in the regions 1606 may be approximately 7mm.

It will therefore also be appreciated that the magnets 500, 600, 800, 1500, 1600, 1700 shown in Figures 5, 6, 8, 15, 16 and 17 may be formed using any suitable method, for example, using a mold with the required shape and height profile as part of a sintering process, or by forming a magnet of uniform thickness with the required shape (e.g., elliptical or circular) and cutting out the required material, for example, using a stamping technique, to form the cut-outs or outer surface profile.

It will also be appreciated that any other suitable configuration may be used, in which the magnet has a substantially circular configuration, but the amount of magnetic material in the region of the magnetic poles (i.e., regions denoted 202 and 204 in Figure 2B) is reduced compared to the regions between the magnetic poles.

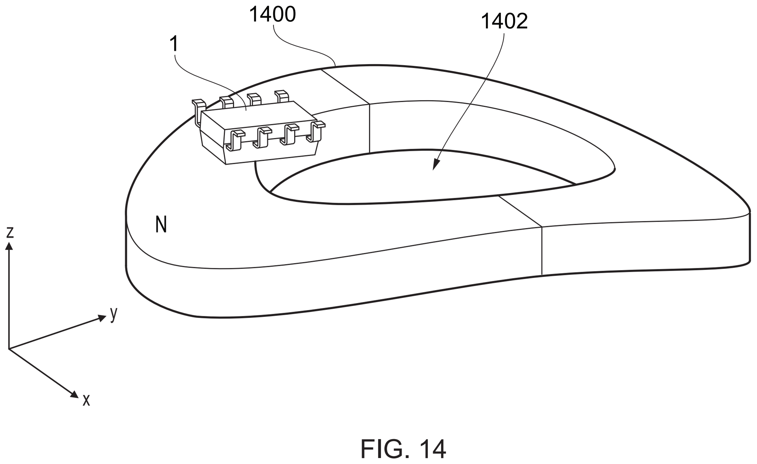

Alternatively, a more homogeneous magnetic field may be provided by configuring the magnet so that the magnetic poles are placed further away from the sensing device 1, such as that shown in Figure 14. Figure 14 shows an example of a magnet 1400 in accordance with the present disclosure, which may again be used with a sensing device 1 such as that shown in Figure 1. In this example, the magnet 1400 is a diametrically magnetized ring magnet that has been shaped so that the regions of the magnet poles (denoted N and S) are further from the sensing device 1 in the direction of the rotational axis (i.e., the z-axis) compared to the regions between the magnetic poles (e.g., the regions where the two halves of the magnet 1400 meet). In other words, the regions of the magnet poles lie in a first plane perpendicular to the rotational axis, whilst the aperture 1402 and the regions between the magnetic poles lie in a second plane perpendicular the rotational axis, the first plane being different to the second plane. The sensing device 1 is then arranged closer to the second plane, that is to say, the sensing device 1 is further from the plane in which the magnetic poles lie. As such, by arranging the sensing device 1400 closer to the parts of the magnet 1400 where the magnetic flux density is weaker and further from the parts of the magnet 1400 where the magnetic flux density is stronger, this will result in the sensing device 1 experiencing an overall homogeneous magnetic field as the magnet 1400 rotates.

The present disclosure also provides a method for improving the accuracy of the angle sensing measurements when the sensing device 1 is placed in an off-shaft position, wherein the magnet is magnetised in a specific direction by applying a current to two sets of electrical conductors positioned on opposite sides of the magnet.

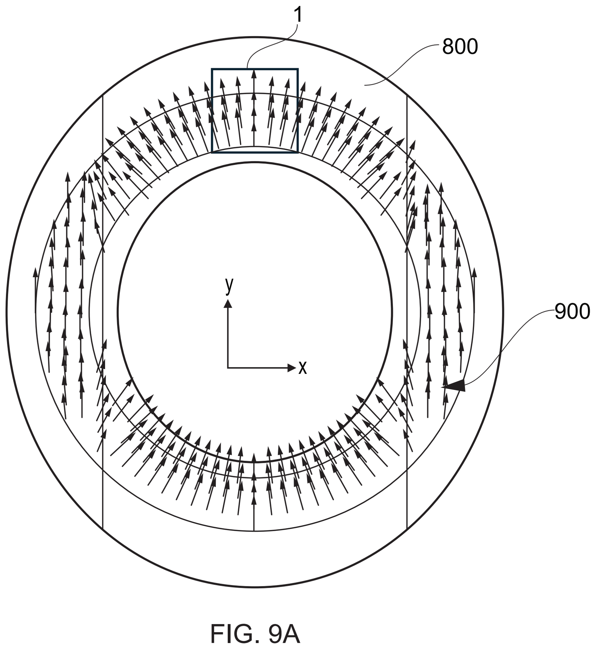

Figures 9A-C show an example of the magnetic field vectors in a ring-shaped corridor (shown generally at 900) above a magnet 800 such as that shown in Figure 8. The corridor 900 generally represents the position of the sensor 1 as the magnet 800 rotates. Ideally, the magnetic field vectors would all point in one direction (the x-direction in this example), however, at the +/- 45° and +/- 135° positions, the vectors are pointing at an angle relative to the x-axis, either into or away from the centre of the magnet 800, which can result in an inaccurate angle measurement when the angle sensor is in these positions. Magnetic angle sensors, in particular, magnetoresistive angle sensors, typically work by detecting a change in resistance based on a change in the direction of magnetization in the sensing elements, wherein the direction of magnetization changes with an external rotating magnetic field. For example, in anisotropic magnetoresistive (AMR) based angle sensors, a change in resistance is detected based on the angle between the direction of the electric current applied and the direction of magnetization in the sensing elements. In giant magnetoresistive (GMR) and tunnel magnetoresistive (TMR) based angle sensors, a change in resistance is detected based on the angle between the magnetization direction of a pinned reference layer (where the magnetization direction remains fixed) and a free layer (where the magnetization direction is free to change in the presence of tan external rotating magnetic field). As such, it is important that magnet 800 is magnetised so that the magnetic field vectors at each angular position along the corridor 900 point in a direction that will result in a corresponding angle measurement by the angle sensor 106.

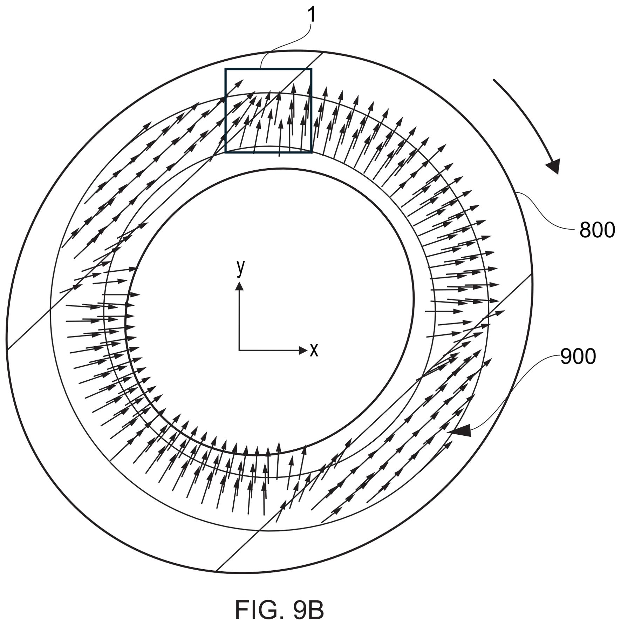

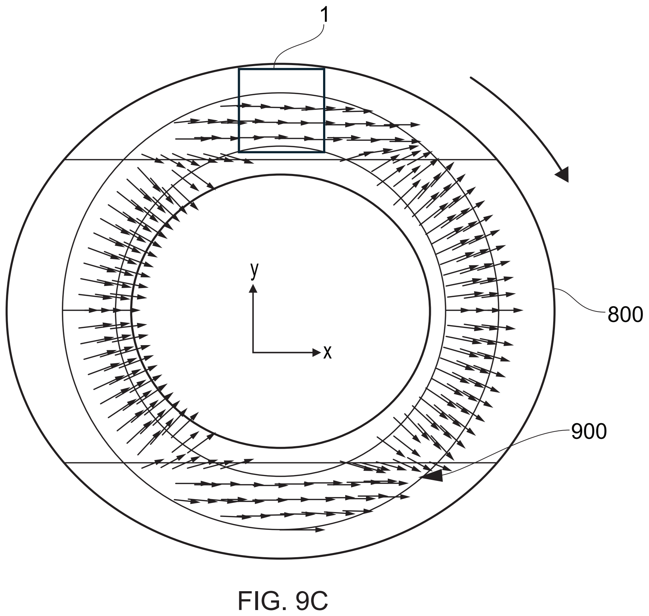

As shown in Figure 9A, in the starting position, the magnetic field vectors in the region of the sensing device 1 are all pointing in the direction of the y-axis. As shown in Figure 9B, the magnet 800 has rotated 45° in a clockwise direction. At this position, the magnetic field vectors in the region of the sensing device 1 are still all mostly pointing in the direction of the y-axis, and consequently, the magnetization direction of the angle sensor 106 will not have changed by a meaningful amount to enable an accurate measurement of the rotation angle to be made. It is not until the magnet 800 rotates a further 45°, as shown in Figure 9C, that the magnetic field vectors in the region of the sensing device 1 are pointing in the direction of the x-axis, which would then result in an angle measurement of 90°. As such, whilst the angle sensor 106 will accurately output measurements at 0° and 90°, the direction of the magnetic field vectors between these positions may result in an incorrect angle measurement.

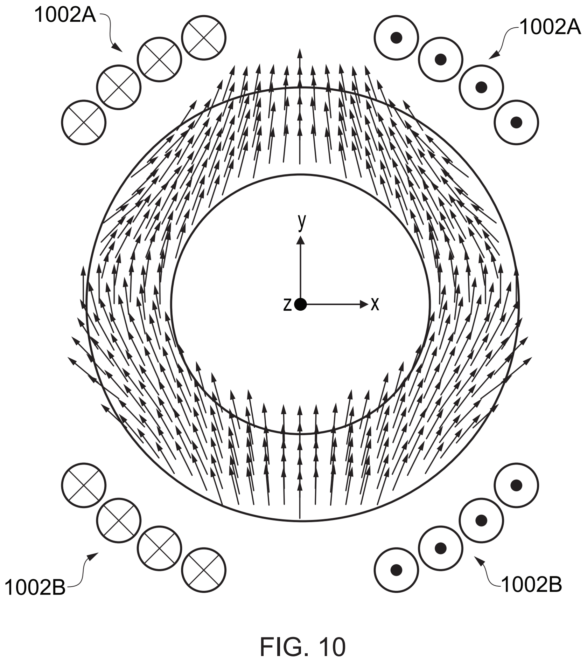

To address this, the magnet is magnetized in a given direction so that the magnetic field vectors experienced by the angle sensor 106 at each angular position of the magnet 800 will result in a corresponding change in magnetisation direction. As shown in Figure 10, arranging electrical conductors 1002A, 1002B, for example, in the form of two coils or two sets of wires located at two opposite sides of the magnet, the magnet can be magnetized in desired direction, specifically, so that they follow the curved path of the magnet, by applying a strong current pulse to the conductors 1002A, 1002B to generate a strong magnetic field in the required direction. For example, a current pulse of at least 1000A may be applied for up to one millisecond. However, it will be appreciated that any suitable current pulse may be applied depending on the size of the magnetic field required. For example, for magnets formed from a ferrite material, a magnetic field having a magnetic flux density of around 0.5T up to 1T may be required. For magnetics formed from a rare earth material, a magnetic field having a magnetic flux density of around 2T or above may be required. In this example, the conductors 1002A, 1002B are arranged along the y-axis, such that applying a current to the conductors 1002A, 1002B generates a strong magnetic field in the y-direction. It will be understood that the conductors shown with a cross indicates current pointing in a direction out of the page, and conductors shown with a dot indicates currents pointing in a direction into the page.

It will also be appreciated that electrical conductors may be arranged in any suitable configuration and position within the vicinity of the magnet, provided that the current pulse applied generates a strong magnetic field in the required direction. For example, a set of wires or a coil may be arranged inside the aperture of the magnet and used to magnetise the magnet in a particular direction.

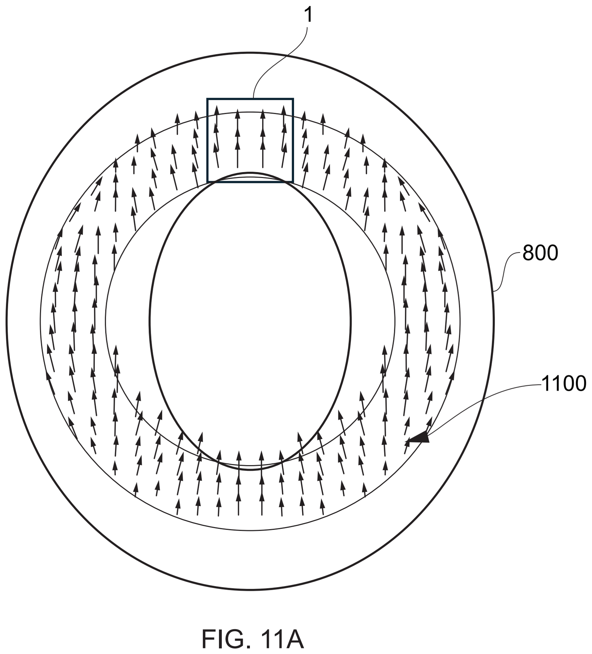

Figures 11A-C illustrate the magnetic field vectors in a ring-shaped corridor (shown generally at 1100) above a magnet 800 such as that shown in Figure 8, which has been magnetised according to the method described with reference to Figure 10.

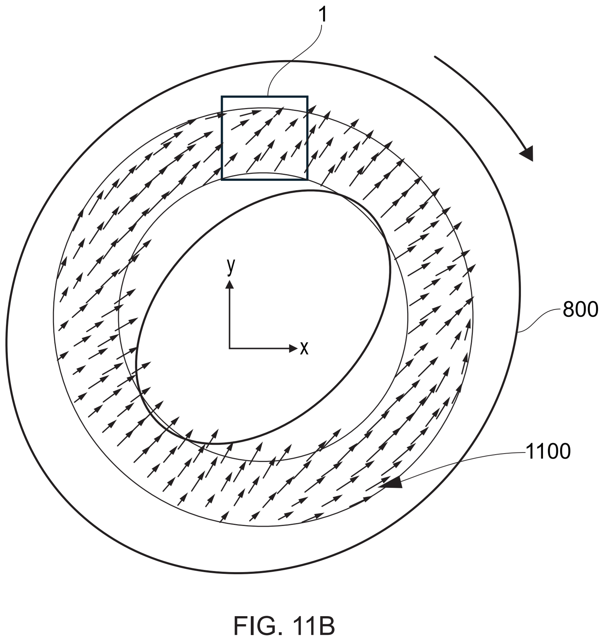

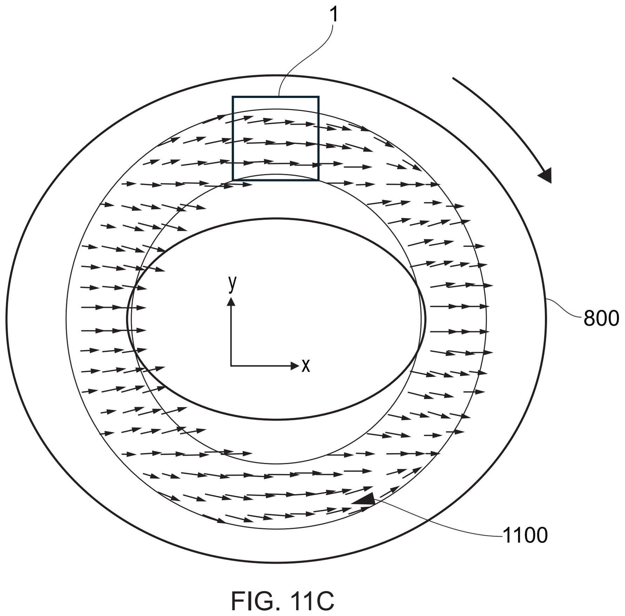

As shown in Figure 11A, in the starting position, the magnetic field vectors in the region of the sensing device 1 are all pointing in the direction of the y-axis. As shown in Figure 11B, the magnet 800 has rotated 45° in a clockwise direction. At this position, the magnetic field vectors in the region of the sensing device 1 are now pointing at a 45° angle, and consequently, the magnetization direction of the angle sensor 106 will have changed by a corresponding amount, and thus the angle sensor 106 will provide a sensor output of 45°. As shown in Figure 11C, the magnetic field vectors in the region of the sensing device 1 after a further 45° turn are pointing in the direction of the x-axis, which would then result in an angle measurement of 90°. As such, by magnetising the magnet 800 in this way, the angle sensor 106 will accurately output measurements at all angular positions.

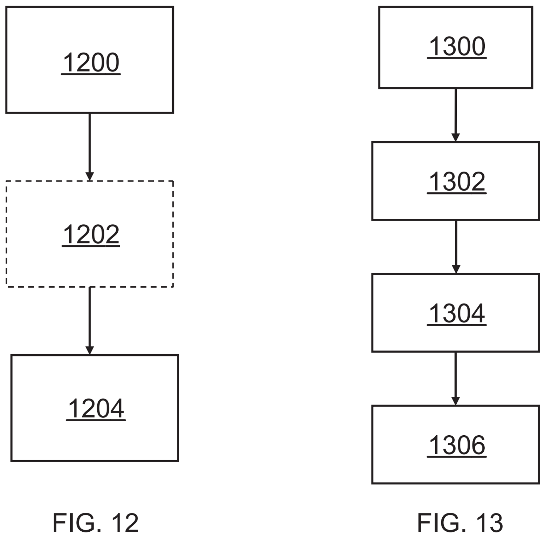

Figure 12 is a flow diagram illustrating the steps of an example of the method by which any of the magnetic arrangements described herein may be manufactured.

At a first step 1200, a magnet is provided in the required shape, for example, using isotropic permanent magnetic material. As one example, the isotropic magnetic material may be mixed with a binder, and then compressed and cured into the required shape, for example, in an elliptical or circular shape. In this respect, the magnetic material may be formed into the required shape using any suitable method, for example, using a mold. Similarly, the magnetic material and binder mixture may be printed using 3D techniques. It will of course be appreciated that any suitable method may be used to form the isotropic magnet in the required shape. At this stage, the magnetic material is not aligned in a specific magnetization direction.

At step 1202, a cut-out may be formed in the magnet using any suitable method, for example, using stamping techniques, laser cutting or any other suitable method for removing a portion of the magnet to thereby provide the required outer surface profile. It will of course be appreciated that, at step 1200, the cut-out may already be provided in the magnet, for example, by having a mold with a shape that incorporates the cut-out or outer surface profile.

At step 1204, the magnet is positioned between a pair of coils or in proximity to other electrical conductors, as described above with reference to Figure 10, and magnetised into the desired direction by applying a current pulse to the coils to generate a strong magnetic field in a particular direction. The magnetised magnet can then be installed on a rotating shaft to be monitored.

Figure 13 is a flow diagram illustrating the steps of a further example of the method by which any of the magnetic arrangements described herein may be manufactured.

At step 1300, an anisotropic magnetic material (e.g., a rare earth magnetic material) is poured into a mold of the desired shape in either a liquid or powder form. At this stage, the magnetic particles are not magnetised into any specific direction.

At step 1302, a magnetic field is applied, for example, using the method described with reference to Figure 10, to the liquid or powder material to align the magnetic particles into the desired direction. In this respect, the current applied to the conductors may be configured to generate a magnetic field in order to align the magnetic particles into the desired direction, for example, the magnetic field may be a constant magnetic field. This step can happen whilst the pouring the liquid or powder into the mold, or directly afterwards before the compound is solidified.

At step 1304, the magnetic material is then solidified into its final shape. This may be done using any suitable method, for example, by baking, sintering or cooling. Once solid, the magnetic alignment will be in the direction defined at step 1302.

At step 1306, the solid magnet will then be positioned in a further coil, which will apply a magnetic field in one particular direction to thereby magnetize the magnet. Due to the particles being aligned in an anisotropic configuration in step 1302, the resulting magnetization is shaped according to Figure 10 regardless of the final magnetization direction. It will also be appreciated that the final magnetization may be performed in any suitable way.

### Applications

Any of the principles and advantages discussed herein can be applied to other systems, not just to the systems described above. Some embodiments can include a subset of features and/or advantages set forth herein. The elements and operations of the various embodiments described above can be combined to provide further embodiments. The acts of the methods discussed herein can be performed in any order as appropriate. Moreover, the acts of the methods discussed herein can be performed serially or in parallel, as appropriate. While circuits are illustrated in particular arrangements, other equivalent arrangements are possible.

Any of the principles and advantages discussed herein can be implemented in connection with any other systems, apparatus, or methods that benefit could from any of the teachings herein. For instance, any of the principles and advantages discussed herein can be implemented in connection with any devices with a need for correcting rotational angle position data derived from rotating magnetic fields. Additionally, the devices can include any magnetoresistance or Hall effect devices capable of sensing magnetic fields.

Aspects of this disclosure can be implemented in various electronic devices or systems. For instance, phase correction methods and sensors implemented in accordance with any of the principles and advantages discussed herein can be included in various electronic devices and/or in various applications. Examples of the electronic devices and applications can include, but are not limited to, servos, robotics, aircraft, submarines, toothbrushes, biomedical sensing devices, and parts of the consumer electronic products such as semiconductor die and/or packaged modules, electronic test equipment, etc. Further, the electronic devices can include unfinished products, including those for industrial, automotive, and/or medical applications.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or "connected", as generally used herein, refer to two or more elements that may be either directly connected, or connected by way of one or more intermediate elements. Thus, although the various schematics shown in the figures depict example arrangements of elements and components, additional intervening elements, devices, features, or components may be present in an actual embodiment (assuming that the functionality of the depicted circuits is not adversely affected). The words "based on" as used herein are generally intended to encompass being "based solely on" and being "based at least partly on." Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values or distances provided herein are intended to include similar values within a measurement error.

While certain embodiments have been described, these embodiments have been presented by way of example only, and are not intended to limit the scope of the disclosure. Indeed, the novel apparatus, systems, and methods described herein may be embodied in a variety of other forms. Furthermore, various omissions, substitutions and changes in the form of the methods and systems described herein may be made without departing from the spirit of the disclosure.

## Claims

1. A magnetic arrangement for use in a magnetic sensing system, the magnetic sensing system comprising a magnetic sensing device arranged at a position offset from a rotational axis of the magnetic arrangement, wherein the magnetic arrangement comprises:
a diametrically magnetized magnet having a substantially cylindrical configuration, the magnet having a first region corresponding to a first magnetic pole and a second region corresponding to a second magnetic pole, the first and second magnetic poles being arranged in diametrically opposite positions; and
an aperture extending from a top surface to a bottom surface of the magnet, the aperture being configured to receive a rotatable shaft;
wherein the magnet comprises a reduced amount of magnetic material in the first and second regions relative to an amount of magnetic material therebetween.

2. The magnetic arrangement according to claim 1, wherein magnet comprises a varying height profile, the height profile in the first and second regions being relatively lower than the height profile therebetween.

3. The magnetic arrangement according to claims 1 or 2, wherein the magnet comprises at least one cut-out to thereby reduce the amount of magnetic material in the first and second regions.

4. The magnetic arrangement according to claim 3, wherein at least one of the following applies:
(i) the at least one cut-out extends between the first region and the second region;
(ii) the at least one cut-out has a substantially rectangular profile;
(iii) the at least one cut-out comprises a sloped surface.

5. The magnetic arrangement according to any preceding claim, wherein the magnet comprises a plurality of cut-outs to thereby provide the reduced amount of magnetic material in the first and second regions relative to the amount of magnetic material therebetween.

6. The magnetic arrangement according to claim 5, wherein the magnet comprises at least one cut-out in the first and second regions, and a plurality of further cut-outs extending around at least a portion of a circumference of the magnet, and optionally wherein the depth of the at least one cut-out in the first and second regions is greater than the depths of the plurality of further cut-outs.

7. The magnetic arrangement according to claim 2, wherein the top surface of the magnet comprises a sinusoidal configuration to thereby provide the varying height profile.

8. The magnetic arrangement according to any preceding claim, wherein the magnet has one of: an elliptical configuration, and a circular configuration, an optionally wherein the aperture has one of: an elliptical configuration, a circular configuration.

9. A magnetic arrangement for use in a magnetic sensing system, the magnetic sensing system comprising a magnetic sensing device arranged at a position offset from a rotational axis of the magnetic arrangement, wherein the magnetic arrangement comprises:
a diametrically magnetized magnet having a substantially cylindrical configuration, the magnet having a first region corresponding to a first magnetic pole and a second region corresponding to a second magnetic pole, the first and second magnetic poles being arranged in diametrically opposite positions; and
an aperture extending from a top surface to a bottom surface of the magnet, the aperture being configured to receive a rotatable shaft;
wherein the magnet is configured such that the first and second regions are formed in a first plane perpendicular to the rotational axis of the magnetic arrangement, and the aperture is formed in a second plane perpendicular to the rotational axis of the magnetic arrangement, the first plane being different from the second plane.

10. A magnetic sensing system, comprising:
a magnetic arrangement according to any preceding claim; and a magnetic sensing device, the magnetic sensing device at least comprising an angle sensor configured to detect an angular rotation of the magnetic field generated by the magnetic arrangement, and a multi-turn sensor configured to detect a number of turns of the magnetic field generated by the magnetic arrangement;
wherein the magnetic sensing device is arranged at a position offset from a rotational axis of the magnetic arrangement.

11. The magnetic sensing system according to claim 10, wherein the magnetic sensing device is at a first position within a plane perpendicular to the rotational axis of the magnet.

12. A method for magnetising a magnetic arrangement for use in a magnetic sensing system, the magnetic sensing system comprising a magnetic sensing device arranged at a position offset from a rotational axis of the magnetic arrangement, wherein the method comprises:
providing an anisotropic magnetic material in a liquid or powder form into a mold of required shape;
placing the anisotropic magnetic material in proximity to at least one set of electrical conductors and applying a current to the at least one set of electrical conductors to generate a magnetic field in a predetermined direction, to thereby align the magnetic particles of the anisotropic magnetic material in the predetermined direction;
solidifying the anisotropic magnetic material to form a magnetic arrangement according to any of claims 1 to 13; and
applying a further magnetic field to thereby magnetize the magnetic arrangement.

13. The method of claim 12, wherein the at least one set of conductors comprise a first set of conductors and a second set of conductors, wherein the anisotropic magnetic material is placed between the first and second set of conductors.

14. The method of claim 13, wherein the first set of conductors comprises a first coil, and the second set of conductors comprises a second coil.

15. The method of claims 13 or 14, wherein the first and second set of conductors are arranged on opposing sides of the anisotropic magnetic material, and optionally wherein the first and second set of conductors are arranged along an axis corresponding to the predetermined direction.
